# EUROPÄISCHE PATENTSCHRIFT

(11) **EP 1 609 880 B1**
(45) Veröffentlichungstag und Bekanntmachung des Hinweises auf die Patenterteilung: **14.05.2008**
(21) Anmeldenummer: 04014534.4
(22) Anmeldetag: 22.06.2004
(51) Int. Cl.: C23C 14/34, H01J 37/34

(54) **Zerstäubungskatode für Beschichtungsprozesse**
Sputtering cathod for coating methods
cathode pour dépot par pulvérisation

(43) Veröffentlichungstag der Anmeldung: 28.12.2005
(73) Patentinhaber: Applied Materials GmbH & Co. KG, 63755 Alzenau (DE)
(72) Erfinder: Ulrich, Jürgen, 61137 Schöneck (DE); Sauer, Peter, 36381 Schlüchtern (DE)
(74) Vertreter: Zapfe, Hans

(56) Entgegenhaltungen:
- EP-A- 0 476 652
- DE-A- 19 755 448
- US-B1- 6 328 856

## Beschreibung

Die Erfindung betrifft eine Zerstäubungskatode für Beschichtungsprozesse in einer Vakuumkammer, mit einer mindestens einteiligen Targetplatte, die auf einer metallischen Membran montiert ist, auf deren der Targetplatte abgewandten Seite sich ein Kühlmittelkanal mit einer Zuflussleitung und einer Abflussleitung für eine Kühlflüssigkeit und ein Hohlraum für mindestens ein Magnetsystem befindet, wobei das Magnetsystem in einer gegenüber der Membran abgedichteten Tragwanne angeordnet und nicht der Kühlflüssigkeit ausgesetzt ist, und wobei die gesamte Anordnung auf einer Tragkonstruktion angeordnet ist.

Derartige Zerstäubungskatoden, sind Hochleistungs-Zerstäubungskatoden und werden auch als Magnetron-Katoden bezeichnet. Dabei ist hinter der Targetplatte ein Magnetsystem angeordnet, das auf der gegenüber liegenden Zerstäubungsfläche einen geschlossenen magnetischen Tunnel erzeugt, in den das für den Zerstäubungsprozess benötigte Plasma aus einem ionisierten Gas eingeschlossen ist. Dadurch wird einerseits die Zerstäubungsrate um den zwanzig- bis dreissigfachen Wert gegenüber einer magnetfreien Katode gesteigert, andererseits aber die Energie-Konzentration auf einen Bereich unterhalb des magnetischen Tunnels konzentriert und damit auch die Abtragungsrate des Materials der Targetplatte und der Wärmeeingang in diese. Dies erzwingt einen kurzfristigen Wechselrhythmus der Targetplatte und eine äusserst wirksame Kühlung. Die Probleme wachsen mit der Grösse der Zerstäubungskatode.

Durch die EP 0 476 652 81 ist es bekannt, kreisförmige, relativ kleine Katodengehäuse, in denen Magnetsysteme untergebracht sind, gegenüber der Vakuum-Beschichtungskammer durch eine relativ dicke Katodenplatte (6 bis 7 mm) zu verschliessen. Durch diese Kathodenplatte und eine umlaufende Rundschnurdichtung ist das Katodengehäuse, in dem sich eine die Magnete umspülende Kühlflüssigkeit befindet, gegenüber der Beschichtungskammer verschlossen. Es ist ausdrücklich angegeben, dass das Eindringen der Kühlflüssigkeit in die Beschichtungskammer zu Produkt-Ausschuss führt, weil dadurch die Beschichtungsatmosphäre - entweder Inertgas oder Reaktivgas - gestört wird. Als Kühlflüssigkeit sind beispielhaft Wasser und Etylenglycol angegeben. Die Kathodenplatte kann entweder homogen oder laminiert ausgebildet sein und aus einer Grundplatte aus Aluminium, dem eigentlichen Target und einer Verstärkungsschicht aus Kupfer bestehen, ggf. noch ergänzt durch eine Heizschicht zum Ausgasen der Katode vor der Beschichtung. Die angegebenen Katodendurchmesser reichen bis 290 mm. Ein wesentlicher Nachteil besteht jedoch darin, dass zum Wechsel der Katodenplatte die Kühlflüssigkeit entfernt, die Dichtung gelöst und gereinigt werden muss, bevor die Wieder-Inbetriebnahme in umgekehrter Richtung nach erheblichen Zeitverlusten erfolgen kann.

Die gleiche Schrift offenbart auch eine Grundplatte, in der - dicht hinter dem zu zerstäubenden Targetmaterial - geschlossene Kühlmittelkanäle angeordnet sind. Hierbei besteht jedoch die Gefahr, dass bei einer Vernachlässigung der überwachung das Targetmaterial durchgeätzt und die Grundplatte bis zu den Kühlmittelkanälen angeätzt wird, womit wiederum die Gefahr eines Eindringens des Kühlmittels in die Beschichtungskammer verbunden ist. Mittel zur Herstellung und Verbindnung der Kühlmittelkanäle mit der Umwelt sind nicht offenbart.

Durch die DE 43 01 516 A1 ist eine Zerstäubungskatode der eingangs beschriebenen Gattung bekannt, bei der ein Kühlmittelkanal zwischen einer elastischen Membran und einer massiven Wanne mit einem umlaufenden Hohlraum und zwei umlaufenden Dichtungen gebildet ist. Auf der Membran liegen ganzflächig Targets oder Targetteile auf. Die Festlegung des Kühlmittelkanals und des/der Targets erfolgt durch alternierend angeordnete Verschraubungen von unten und oben, die einerseits über Pratzen oder Muttern auf die Membran mit der Wanne und andererseits auf die Targetränder einwirken. Hierbei liegen die Magnete ausserhalb des Kühlmittels. Da die gesamte Zerstäubungskatode jedoch innerhalb einer nicht gezeigten Vakuumkammer angeordnet ist, könnte etwa austretendes Kühlmittel in die Vakuumkammer eintreten und den Beschichtungsprozess negativ beeinflussen.

Durch die DE 196 22 605 A1 und die DE 196 22 606 C2 ist es bekannt, zwischen dem Magnetsystem und der Targetplatte mindestens einen Blechzuschnitt aus einem magnetisch leitfähigen Material anzuordnen, um den Feldlinien, die einen magnetischen Tunnel für das die Zerstäubung bewirkende Plasma bilden, einen flacheren Verlauf aufzuzwingen, um den Erosionsgraben in der Targetplatte zu verbreitern und den Materialwirkungsgrad zu erhöhen. Die DE 196 22 606 C2 offenbart zusätzlich noch eine Tragetgrundplatte, die das Target trägt.

Duch DE 197 55 448 A ist es bekannt, eine Zerstäubungskathode für Beschichtungsprozesse, die auf einer metallischen Membran montiert ist und die einen Kühlmittelkanal enthält. US-B-6 328 8561 offentbart eine Kathode, die eine Tragkonstruktion besitzt, die unter Atmosphärendruck ist.

Der Erfindung liegt daher die Aufgabe zugrunde, bei einer Zerstäubungskatode der eingangs beschriebenen Gattung den Wärmeübergang vom Target zum Kühlmittel auf einfache, wirksame und kostengünstige Weise zu verbessern und die Gefahr eines Eindringens von Kühlmittel oder dessen Dämpfen in die Vakuumkammer und die Beeinträchtigung des Beschichtungsprozesses zu vermeiden.

Die Lösung der gestellten Ausgabe erfolgt bei einer Zerstäubungskatode der eingangs beschriebenen Gattung erfindungsgemäss dadurch, dass
a) die Tragkonstruktion für die Zerstäubungskatode einen Hohlkörper besitzt, der gegenüber dem Innenraum der Vakuumkammer gasdicht verschlossen ist und der den das Magnetsystem umgebenden Hohlraum mit der ausserhalb der Vakuumkammer befindlichen Atmosphäre verbindet,
b) der Kühlmittelkanal als auf seinem Querschnittsumfang geschlossenes Leitungsrohr mit mindestens einer Flachseite ausgebildet ist, die mit der Membran in einer Wärme leitenden Verbindung steht, und dass
c) die Membran und die der Membran abgewandten Oberflächen des Leitungsrohres über die besagte Tragkonstruktion dem Atmosphärendruck außerhalb der Vakuumkammer ausgesetzt sind.

Durch die Erfindung wird bei einer Zerstäubungskatode der eingangs beschriebenen Gattung der Wärmeübergang vom Target zum Kühlmittel auf einfache, wirksame und kostengünstige Weise verbessert und die Gefahr eines Eindringens von Kühlmittel oder dessen Dämpfen in die Vakuumkammer und die Beeinträchtigung des Beschichtungsprozesses vermieden.

Es ist dabei im Zuge weiterer Ausgestaltungen der Erfindung besonders vorteilhaft, wenn - entweder einzeln oder in Kombination -
* das Leitungsrohr für die Kühlflüssigkeit einen Rechteck-Querschnitt aufweist, dessen eine Langseite mit der Membran in einer Wärme leitenden Verbindung steht,
* das Leitungsrohr für die Kühlflüssigkeit durch einen Fügeprozess mit der Membran verbunden ist,
* der Hohlkörper der Tragkonstruktion an einer Halteplatte befestigt ist, die an einer Wand der Vakuumkammer befestigt ist, die innerhalb der Verbindungsstelle der Halteplatte eine öffnung gegenüber der Umgebungsatmosphäre aufweist,
* an die beiden Enden des Leitungsrohres senkrechte Rohrstutzen angeschlossen sind, die in Krümmern enden und von denen Anschlussleitungen durch den Hohlkörper der Tragkonstruktion bis an die Umgebungsatmosphäre geführt sind,
* die Tragwanne der Zerstäubungskatode über einen auf dem Umfang geschlossenen Stützkörper vakuumdicht mit dem Hohlkörper der

Tragkonstruktion verbunden ist,
* die Tragwanne der Zerstäubungskatode und die Halterungen für die Targetplatte(n) von einem Gehäuse umgeben sind, das mittels eines ersten Rahmens die Halterungen der Targetplatte(n) übergreift und mittels eines zweiten Rahmens die Tragwanne bis in die Nähe des Stützkörpers untergreift, und/oder, wenn
* das Leitungsrohr innerhalb der Zerstäubungskatode etwa mittig zwischen den unterschiedlichen Polen des Magnetsystems verläuft.

Ein Ausführungsbeispiel des Erfindungsgegenstandes und dessen Wirkungsweise und Vorteile werden nachfolgend anhand einer Rechteck-Katode gemäß den Figuren 1 bis 6 näher erläutert.

### Es zeigen:

- Figur 1: einen Vertikalschnitt durch ein vollständiges Katodensystem mit Tragkonstruktion innerhalb eines Ausschnitts einer Vakuumkammer mit einer Schnittebene senkrecht zur Katoden-Längsachse,
- Figur 2: einen teilweisen vertikalen Längsschnitt durch dasjenige Ende des Katodensystems, an dem das Leitungsrohr für die Kühlmittelversorgung angeschlossen ist, allerdings ohne Tragkonstruktion und in vergrössertem Massstab,
- Figur 3: das andere Ende des Katodensystems gegenüber Figur 2, an dem das Leitungsrohr um 180 Grad umgelenkt ist,
- Figur 4: eine Draufsicht auf das Magnetsystem nach Abnahme der Targetplatte in verkleinertem Massstab,
- Figur 5: eine Draufsicht auf ein Ende des Katodensystems, und
- Figur 6: einen senkrechten Querschnitt durch das Katodensystem nach den Figuren 2, 3 und 5.

Es sei vorab betont, dass die Zerstäubungskatode als Rechteck-Katode dargestellt ist, deren Länge für die Grossflächenbeschichtung mittels einer relativen Längsbewegung von Glas mehrere Meter betragen kann, dass das Konstruktionsprinzip jedoch sehr wohl auch für beliebig grosse Rundkatoden verwendet werden kann. Der Einsatz ist naturgemäss auch in umgekehrter, d.h. in "über-Kopf-Lage" oder auch in beliebigen Schräglagen, z. B. bei einer Folienbeschichtung auf Walzen möglich.

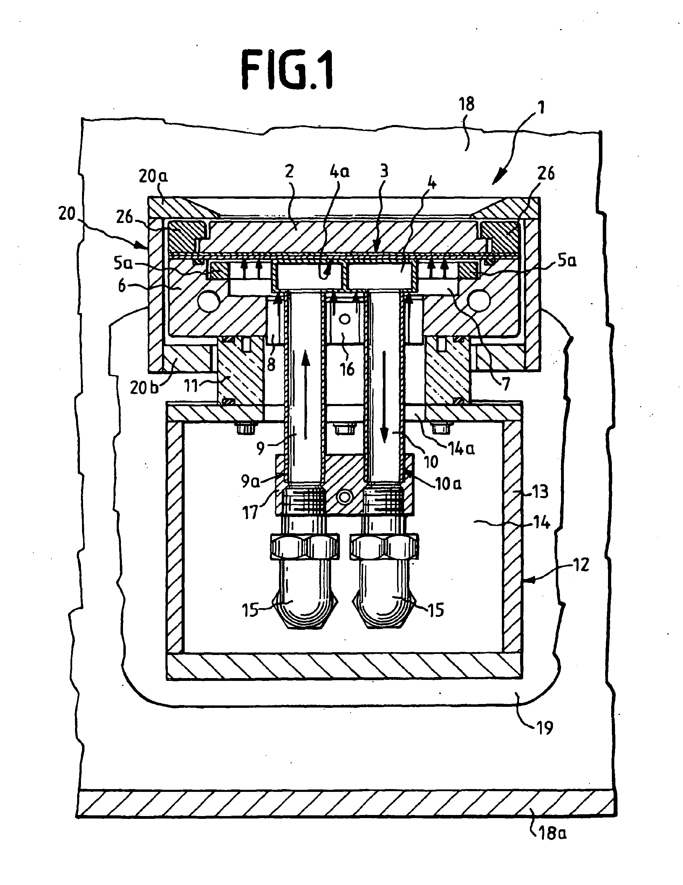

In Figur 1 ist eine Zerstäubungskatode 1 dargestellt, deren funktionswesentlicher Teil eine Targetplatte 2 ist, die im Betrieb das Beschichtungsmaterial oder eine Komponente davon liefert, je nachdem, ob das Verfahren in inerter (z.B. Argon) oder reaktiver Atmosphäre (z.B. Sauerstoff oder Stickstoff) durchgeführt wird. Die Targetplatte 2 kann monolithisch oder aus Schichten aufgebaut sein, was aber bekannt ist.

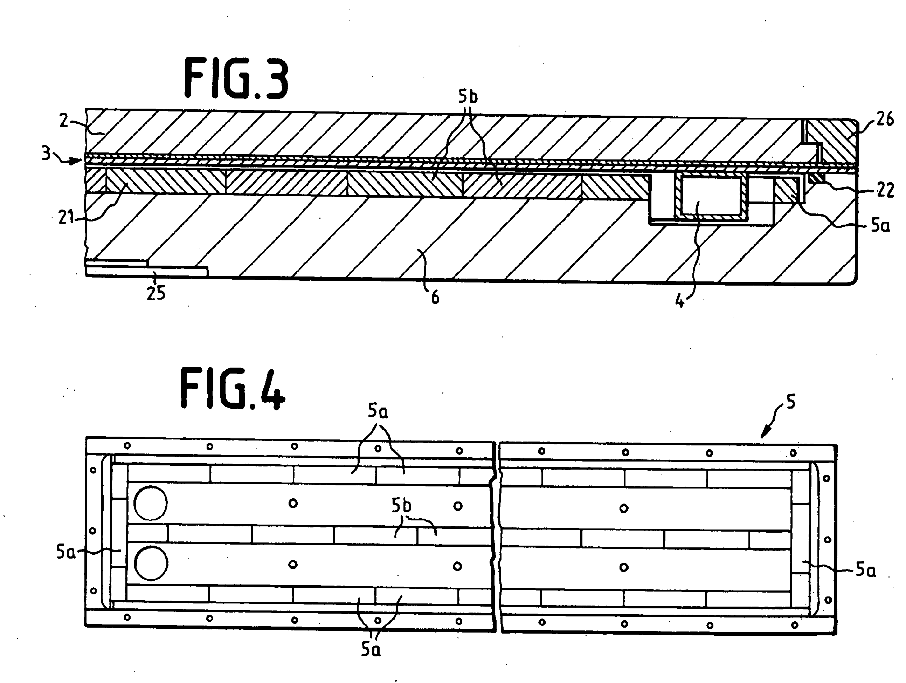

Hinter der Targetplatte 2 befindet sich zunächst eine elastische Membran 3 aus Metall, die gleichfalls ein- oder mehrschichtig aufgebaut sein kann. Z.B. kann eine der Schichten 3a aus Eisen, Stahl und/oder Edelstahl bestehen und die andere Schicht 3b aus Kupfer. Die Schicht 3a dient dazu, den bogenförmigen Verlauf der Feldlinien, die den magnetischen Tunnel einschliessen, abzuflachen, um die Erosionsgräben in der Targetplatte zu verbreitern und den Materialwirkungsgrad zu erhöhen. In Wärme leitender Verbindung mit der Schicht 3b steht ein etwa U-förmiger Kühlmittelkanal aus einem Leitungsrohr 4, dessen Querschnitt rechteckig ausgebildet ist und dessen obere Flachseite 4a in gut Wärme leitender Verbindung mit der Targetplatte 2 steht. Diese Verbindung wird vorzugsweise durch ein Fügeverfahren aus der Gruppe Löten, Schweissen oder Kleben mit einem Wärme leitenden Kleber hergestellt. Mit einem Abstand dahinter ist ein Magnetsystem 5 (Figur 4) angeordnet, von dem hier nur die äußere Magnetreihe 5a gezeigt ist. Die Schichten 3a und 3b haben eine Gesamtdicke von 2 bis 4 mm, sind aber vorzugsweise nicht fest miteinander verbunden, um die Elastizität durch relative Verschiebbarkeit grösstmöglich zu halten.

Die Membran 3 und das Magnetsystem 5 werden von einer Tragwanne 6 gehalten, die einen entsprechend geformten, stufenförmigen Hohlraum 7 und eine Durchgangsöffnung 8 für eine Zuflussleitung 9 und eine Abflussleitung 10 für eine Kühlflüssigkeit besitzt. Die gesamte Anordnung ist über einen auf dem Umfang geschlossenen Stützkörper 11 auf einer Tragkonstruktion 12 gehalten, die einen Hohlkörper 13 aufweist und einen quaderförmigen Hohlraum 14 mit einer oberen öffnung 14a umschliesst. Dieser Hohlraum 14 ist auf die nachstehend noch näher beschriebene Weise mit der äusseren Atmosphäre verbunden. Die kurzen dicken, gegen die Membran 3 und das Leitungsrohr 4 gerichteten Pfeile symbolisieren die Anpresskräfte durch den äußeren Atmosphärendruck, der bis in den Hohlraum 7 der Tragwanne 6 vordringt.

Die Leitungen 9 und 10 sind als Rohrstutzen 9a und 10a ausgebildet und enden in Krümmern 15, an die weitere - hier nicht gezeigte - Leitungen angeschlossen sind, die in Längsrichtung durch den Hohlraum 14 bis an die äußere Atmosphäre hindurchgeführt sind. Zur Einhaltung der Distanz zwischen den Rohrstutzen 9a und 10a dienen Klemmvorrichtungen 16 und 17. Die Dichtungen für den vakuumdichten Verschluss zwischen der Beschichtungs- und der äußeren Atmosphäre sind durch schwarze Rechtecke angedeutet und hier nicht näher beziffert.

Die bisher beschriebene Anordnung ist in einer Vakuumkammer 18 untergebracht, von der hier nur ein Ausschnitt und der Boden 18a dargestellt sind. Zu diesem Zweck ist der Hohlkörper 13 der Tragkonstruktion 12 an einer Halteplatte 19 befestigt, die vakuumdicht an einer Wand der Vakuumkammer 18 befestigt ist. Die besagte Wand enthält innerhalb der Halteplatte 19 bzw. der Verbindungsstelle eine hier nicht gezeigte öffnung gegenüber der Umgebungs- bzw. Aussenatmosphäre.

Gezeigt ist noch, dass die Zerstäubungskatode 1 mit ihrer Tragwanne 6 von einem Gehäuse 20 umgeben ist, das mittels eines ersten, oberen Rahmens 20a die Halterungen und Ränder der Targetplatte 2 übergreift und mittels eines zweiten, unteren Rahmens 20b die Tragwanne 6 bis in die Nähe des Stützkörpers 11 untergreift.

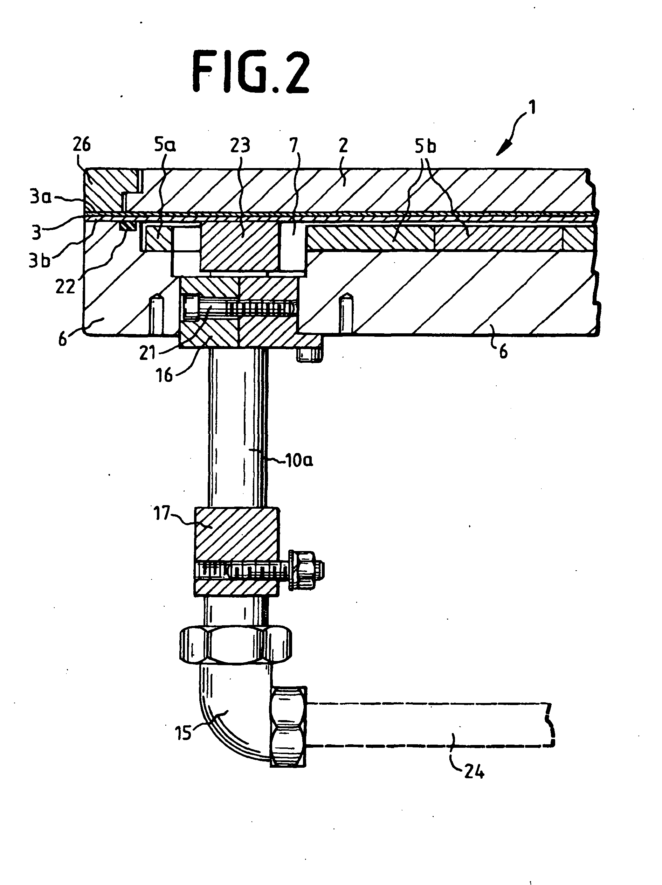

Die Figuren 2 bis 6 zeigen unter Beibehaltung und Fortschreibung der bisherigen Bezifferung in vergrössertem Massstab folgendes:

Die Figur 2 zeigt einen teilweisen vertikalen Längsschnitt durch dasjenige Ende des Katodensystems, an dem die Rohrstutzen 9a und 10a für die Kühlmittelversorgung an das Leitungsrohr 4 angeschlossen sind, allerdings ohne Tragkonstruktion 12. Der Längsschnitt verläuft durch die bisher nicht gezeigte mittlere Magnetreihe 5b, eine Zugschraube 21 durch die Klemmvorrichtung 16 und einen Teilumfang einer der Dichtungen 22, eine Trennwand 23 zwischen den anschlussseitigen Enden des Leitungsrohres 4 und - gestrichelt - eine der waagrechten Anschlussleitungen 24 die bis an die äussere Atmosphäre geführt sind.

Die Figur 3 zeigt das andere Ende des Katodensystems gegenüber Figur 2, an dem das Leitungsrohr 4 um 180 Grad umgelenkt ist. Eine stufenförmige Ausnehmung 25, dient zur Aufnahme einer hier nicht gezeigten Stützvorrichtung gegenüber der Tragkonstruktion 12.

Die Figur 4 zeigt eine Draufsicht auf das Magnetsystem 5 bzw. 5a und 5b nach Abnahme der Targetplatte 2. Dieses Magnetsystem erzeugt ein die Targetplatte 2 durchdringendes Magnetfeld mit bogenförmigen Feldlinien und mit rennbahnähnlicher Konfiguration, das ein gleichförmiges Plasma einschliesst, das durch eine Potentialdifferenz zwischen der Zerstäubungskatode 1 und einer nicht gezeigten Anode gebildet wird, die durch einen Anodenkörper und/oder durch einen auf Massepotenzial liegenden, gleichfalls nicht gezeigten, Substrathalter angeregt wird. Das besagte Plasma zerstäubt unter hohem Energieeintrag das Material der Targetplatte 2 und sorgt für eine Kondensation des abgestäubten Materials oder einer Verbindung davon auf den Substraten. Solche Ursachenzusammenhänge, die eine wirksame Kühlung bedingen, sind jedoch bekannt und werden daher nicht näher erläutert.

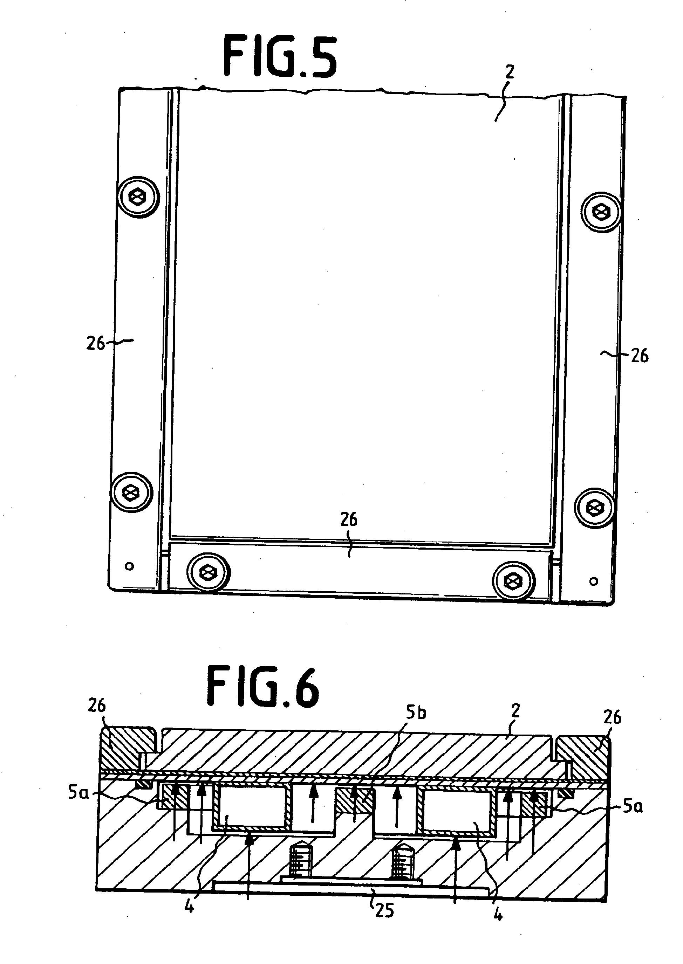

Die Figur 5 zeigt eine Draufsicht auf ein Ende des Katodensystems. Die Targetplatte 2 wird aufgrund einer Z-förmigen Ausbildung der Trennfugen durch einen Rahmen aus mit der Tragwanne 6 verschraubten Pratzleisten 26 gehalten, die auch die Membran 3 gegenüber der Tragwanne 6 einspannen.

Die Figur 6 zeigt - gegenüber Figur 1 vergrössert - einen senkrechten Querschnitt durch das Katodensystem nach den Figuren 2, 3 und 5. Nochmals dargestellt sind durch dicke schwarze Pfeile die Krafteinwirkungen des äusseren Atmospärendrucks auf die Membran 3 und das Leitungsrohr 4. Die äusseren Magnetreihen 5a sind spiegelsymmetrisch zur inneren Magnetreihe 5b angeordnet. In dem Zwischenraum 7 sind mit Abständen zu den äußeren Magnetreihen 5a und zur mittleren Magnetreihe 5b die beiden Schenkel des Leitungsrohres 4 angeordnet. Dadurch lassen sich die Membran 3 und die Targetplatte 2 in äusserst wirksamer Weise kühlen und - nach dem Aufheizen - auf konstanter Temperatur halten. Es wird noch betont, dass sich auch zwischen den oberen Begrenzungsflächen der Magnetreihen 5a und 5b Abstände bzw. Luftspalte befinden.

### Bezugszeichenliste:

- 1: Zerstäubungskatode
- 2: Targetplatte
- 3: Membran
- 3a: Schicht
- 3b: Schicht
- 4: Leitungsrohr
- 4a: Flachseite
- 5: Magnetsystem
- 5a: äußere Magnetreihe
- 5b: innere Magnetreihe
- 6: Tragwanne
- 7: Hohlraum
- 8: Durchgangsöffnung
- 9: Zuflussleitung
- 9b: Rohrstutzen
- 10: Abflussleitung
- 10a: Rohrstutzen
- 11: Stützkörper
- 12: Tragkonstruktion
- 13: Hohlkörper
- 14: Hohlraum
- 14a: öffnung 14a
- 15: Krümmer
- 16: Klemmvorrichtung
- 17: Klemmvorrichtung
- 18: Vakuumkammer
- 18a: Boden
- 19: Halteplatte
- 20: Gehäuse
- 20a: Rahmen
- 20b: Rahmen
- 21: Zugschraube
- 22: Dichtungen
- 23: Trennwand
- 24: Anschlussleitung
- 25: Ausnehmung
- 26: Pratzleisten

## Patentansprüche

1. Zerstäubungskatode für Beschichtungsprozesse in einer Vakuumkammer (18), mit einer mindestens einteiligen Targetplatte (2), die auf einer metallischen Membran (3) montiert ist, auf deren der Targetplatte (2) abgewandten Seite sich ein Kühlmittelkanal mit einer Zuflussleitung (9) und einer Abflussleitung (10) für eine Kühlflüssigkeit und ein Hohlraum (7) für mindestens ein Magnetsystem (5) befindet, wobei das Magnetsystem (5) in einer gegenüber der Membran (3) abgedichteten Tragwanne (6) angeordnet und nicht der Kühlflüssigkeit ausgesetzt ist, und wobei die gesamte Anordnung auf einer Tragkonstruktion (12) angeordnet ist,
**dadurch gekennzeichnet, dass**
a) die Tragkonstruktion (12) für die Zerstäubungskatode (1) einen Hohlkörper (13) besitzt, der gegenüber dem Innenraum der Vakuumkammer (18) gasdicht verschlossen ist und der den das Magnetsystem (5) umgebenden Hohlraum (7) mit der ausserhalb der Vakuumkammer (18) befindlichen Atmosphäre verbindet,
b) der Kühlmittelkanal als auf seinem Querschnittsumfang geschlossenes Leitungsrohr (4) mit mindestens einer Flachseite (4a) ausgebildet ist, die mit der Membran (3) in einer Wärme leitenden Verbindung steht, und dass
c) die Membran (3) und die der Membran (3) abgewandten Oberflächen des Leitungsrohres (4) über die besagte Tragkonstruktion (12) dem Atmosphärendruck außerhalb der Vakuumkammer (18) ausgesetzt sind.

2. Zerstäubungskatode nach Anspruch 1, **dadurch gekennzeichnet, dass** das Leitungsrohr (4) für die Kühlflüssigkeit einen Rechteck-Querschnitt aufweist, dessen eine Langseite mit der Membran (3) in einer Wärme leitenden Verbindung steht.

3. Zerstäubungskatode nach Anspruch 1, **dadurch gekennzeichnet, dass** das Leitungsrohr (4) für die Kühlflüssigkeit durch einen Fügeprozess mit der Membran (3) verbunden ist.

4. Zerstäubungskatode nach Anspruch 1, **dadurch gekennzeichnet, dass** der Hohlkörper (13) der Tragkonstruktion (12) an einer Halteplatte (19) befestigt ist, die an einer Wand der Vakuumkammer (18) befestigt ist, die innerhalb der Verbindungsstelle der Halteplatte (19) eine öffnung gegenüber der Umgebungsatmosphäre aufweist.

5. Zerstäubungskatode nach Anspruch 4, **dadurch gekennzeichnet, dass** an die beiden Enden des Leitungsrohres (4) senkrechte Rohrstutzen (9a, 10a) angeschlossen sind, die in Krümmern (15) enden und von denen Anschlussleitungen durch den Hohlkörper (13) der Tragkonstruktion (12) bis an die Umgebungsatmosphäre geführt sind.

6. Zerstäubungskatode nach Anspruch 1, **dadurch gekennzeichnet, dass** die Tragwanne (6) der Zerstäubungskatode (1) über einen auf dem Umfang geschlossenen Stützkörper (11) vakuumdicht mit dem Hohlkörper (13) der Tragkonstruktion (12) verbunden ist.

7. Zerstäubungskatode nach Anspruch 6, **dadurch gekennzeichnet, dass** die Tragwanne (6) der Zerstäubungskatode (1) und die Halterungen für die Targetplatte(n) (2) von einem Gehäuse (20) umgeben sind, das mittels eines ersten Rahmens (20a) die Halterungen der Targetplatte(n) (2) übergreift und mittels eines zweiten Rahmens (20b) die Tragwanne (6) bis in die Nähe des Stützkörpers (11) untergreift.

8. Zerstäubungskatode nach Anspruch 1, **dadurch gekennzeichnet, dass** das Leitungsrohr (4) innerhalb der Zerstäubungskatode (1) etwa mittig zwischen den unterschiedlichen Polen des Magnetsystems (5) verläuft.

## Claims

1. A sputtering cathode for coating processes in a vacuum chamber (18), having an at least one-piece target plate (2) mounted on a metallic membrane (3) on whose side remote from the target plate (2) there is located a coolant channel with an inflow line (9) and an outflow line (10) for a coolant and a hollow chamber (7) for at least one magnet system (5), the magnet system (5) being arranged in a supporting trough (6) sealed with respect to the membrane (3) and not being exposed to the coolant, and the entire arrangement being arranged on a supporting structure (12), **characterised in that**
a) the supporting structure (12) for the sputtering cathode (1) has a hollow body (13) which is closed in a gas-tight manner with respect to the interior of the vacuum chamber (18) and which connects the hollow chamber (7) surrounding the magnet system (5) to the atmosphere located outside of the vacuum chamber (18),
b) the coolant channel is in the form of a conduit pipe (4), closed over its cross-sectional circumference, with at least one flat side (4a) connected to the membrane (3) in a heat-conducting manner, and **in that**
c) the membrane (3) and those surfaces of the conduit pipe (4) remote from the membrane (3) are exposed to the atmospheric pressure outside of the vacuum chamber via the aforesaid supporting structure (12).

2. A sputtering cathode according to claim 1, **characterised in that** the conduit pipe (4) for the coolant has a rectangular cross-section whose one long side is connected to the membrane (3) in a heat-conducting manner.

3. A sputtering cathode according to claim 1, **characterised in that** the conduit pipe (4) for the coolant is connected to the membrane (3) by a joining process.

4. A sputtering cathode according to claim 1, **characterised in that** the hollow body (13) of the supporting structure (12) is secured to a holding plate (19) secured to a wall of the vacuum chamber (18), which wall has, within the point of connection of the holding plate (19), an opening to the ambient atmosphere.

5. A sputtering cathode according to claim 4, **characterised in that** attached to the two ends of the conduit pipe (4) are perpendicular pipe connections (9a, 10a) which end in knees (15) and from which connecting lines lead through the hollow body (13) of the supporting structure (12) as far as the ambient atmosphere.

6. A sputtering cathode according to claim 1, **characterised in that** the supporting trough (6) of the sputtering cathode (1) is connected to the hollow body (13) of the supporting structure (12) in a vacuum-tight manner via a support body (11) closed over its circumference.

7. A sputtering cathode according to claim 6, **characterised in that** the supporting trough (6) of the sputtering cathode (1) and the mountings for the target plate(s) (2) are surrounded by a housing (20) which by means of a first frame (20a) engages over the mountings of the target plate(s) (2) and by means of a second frame (20b) engages underneath the supporting trough (6) right to the vicinity of the support body (11).

8. A sputtering cathode according to claim 1, **characterised in that** within the sputtering cathode (1), the conduit pipe (4) runs substantially centrally between the different poles of the magnet system (5).

## Revendications

1. Cathode de pulvérisation destinée à des processus de dépôt ou de revêtement dans une chambre à vide (18), comprenant une plaque-cible (2) au moins d'un seul tenant, qui est montée sur une membrane métallique (3) sur la face de laquelle, qui est éloignée de la plaque-cible (2), se trouve un canal de fluide de refroidissement avec une conduite d'écoulement d'amenée (9) et une conduite d'écoulement d'évacuation (10) pour un liquide de refroidissement, et au moins une cavité (7) pour un système magnétique (5), le système magnétique (5) étant agencé dans un bac de support (6) rendu étanche par rapport à la membrane (3) et n'étant pas exposé au liquide de refroidissement, et l'ensemble de l'agencement étant disposé sur une construction de support (12), **caractérisée**
a) **en ce que** la construction de support (12) pour la cathode de pulvérisation (1) possède un corps creux (13) qui est fermé de manière étanche aux gaz par rapport à l'espace intérieur de la chambre à vide (18), et relie la cavité (7) entourant le système magnétique (5), à l'atmosphère située à l'extérieur de la chambre à vide (18),
b) **en ce que** le canal de fluide de refroidissement est réalisé sous la forme d'une conduite tubulaire (4) fermée le long de la périphérie de sa section transversale et comportant au moins une face plate (4a) qui est en liaison de conduction de chaleur avec la membrane (3), et
c) **en ce que** la membrane (3) et les surfaces externes de la conduite tubulaire (4), éloignées de la membrane (3), sont exposées, par l'intermédiaire de ladite construction de support (12), à la pression atmosphérique à l'extérieur de la chambre à vide (18).

2. Cathode de pulvérisation selon la revendication 1, **caractérisée en ce que** la conduite tubulaire (4) pour le liquide de refroidissement présente une section transversale rectangulaire, dont un grand côté est en liaison de conduction de la chaleur avec la membrane (3).

3. Cathode de pulvérisation selon la revendication 1, **caractérisée en ce que** la conduite tubulaire (4) pour le liquide de refroidissement est reliée à la membrane (3) par un processus d'assemblage jointif.

4. Cathode de pulvérisation selon la revendication 1, **caractérisée en ce que** le corps creux (13) de la construction de support (12) est fixé sur une plaque de support (19) fixée sur une paroi de la chambre à vide (18) qui présente, à l'intérieur de la zone de liaison de la plaque de support (19), une ouverture par rapport à l'atmosphère environnante.

5. Cathode de pulvérisation selon la revendication 4, **caractérisée en ce qu'**aux deux extrémités de la conduite tubulaire (4) sont raccordés des embouts de tube (9a, 10a) verticaux, qui se terminent dans des coudes (15), et à partir desquels des conduites de raccordement mènent à travers les corps creux (13) de la construction de support (12) jusqu'à l'atmosphère environnante.

6. Cathode de pulvérisation selon la revendication 1, **caractérisée en ce que** le bac de support (6) de la cathode de pulvérisation (1) est relié de manière étanche au vide, au corps creux (13) de la construction de support (12), par l'intermédiaire d'un corps d'appui (11) fermé en périphérie.

7. Cathode de pulvérisation selon la revendication 6, **caractérisée en ce que** le bac de support (6) de la cathode de pulvérisation (1) et les supports de maintien pour la ou les plaque(s)-cible(s) (2) sont entourés par un carter (20) qui, au moyen d'un premier cadre (20a), surmonte les supports de maintien de la ou des plaque(s)-cible(s) (2), et, au moyen d'un deuxième cadre (20b) s'engage sous le bac de support (6) jusqu'à proximité du corps d'appui (11).

8. Cathode de pulvérisation selon la revendication 1, **caractérisée en ce que** la conduite tubulaire (4) s'étend à l'intérieur de la cathode de pulvérisation (1), environ au milieu entre les différents pôles du système magnétique (5).
